# EUROPEAN PATENT APPLICATION

(11) **EP 1 258 917 A1**
(43) Date of publication of application: **20.11.2002**
(21) Application number: 00978004.0
(22) Date of filing: 29.11.2000
(51) Int. Cl.: H01L 21/68, B65D 85/90

(54) **METHOD AND DEVICE FOR PREVENTING OXIDATION ON SUBSTRATE SURFACE**

(30) Priority: 28.12.1999 JP 37508699
(71) Applicant: EBARA CORPORATION, Ohta-ku, Tokyo 144-8510 (JP)
(72) Inventor: FUJII, Toshiaki, Yamato-shi, Kanagawa 242-0002 (JP); YOKOYAMA, Shin, Higashihiroshima-shi, Hiroshima 739-2115 (JP); YOSHINO, Takenobu, Higashihiroshima-shi, Hiroshima 739-0041 (JP)
(74) Representative: Wagner, Karl H., Dipl.-Ing.
(86) International application number: JP0008419
(87) International publication number: WO01048813

(57) **Abstract**

The present invention provides a method of and an apparatus for preventing a substrate from being oxidized to suppress the production of a natural oxide film in an ordinary air atmosphere rather than a vacuum or inactive gas atmosphere. The present invention is characterized in that a substrate is stored in a closed space surrounded by a light-shielding member to suppress the growth of a natural oxide film on the substrate. In the space, it is preferable to store the substrate while removing a gaseous contaminant or both a gaseous contaminant and a particulate substance. Since a semiconductor substrate is stored in the space surrounded by the light-shielding member, no light is applied to the surface of the semiconductor substrate, thus suppressing the generation of a natural oxide film. The method is capable of suppressing the generation of a natural oxide film easily at a low cost without using a vacuum or inactive gas atmosphere because the process can be performed within air.

## Description

### Technical Field

The present invention relates to a method of preventing the surface of a semiconductor substrate or the like from being oxidized in a cleanroom or the like, and more particularly to an oxidization prevention method and apparatus for preventing a natural oxide film from growing on the surface of a semiconductor substrate or the like.

The present invention can preferably be applied to delivery boxes (carrier boxes), stockers, clean boxes, delivery spaces, interfaces (transfer devices), etc. for silicon semiconductor substrates, metal-covered substrates, etc.

### Background Art

The problem of contamination in manufacturing processes of silicon semiconductor substrates in the prior art will briefly be described below.

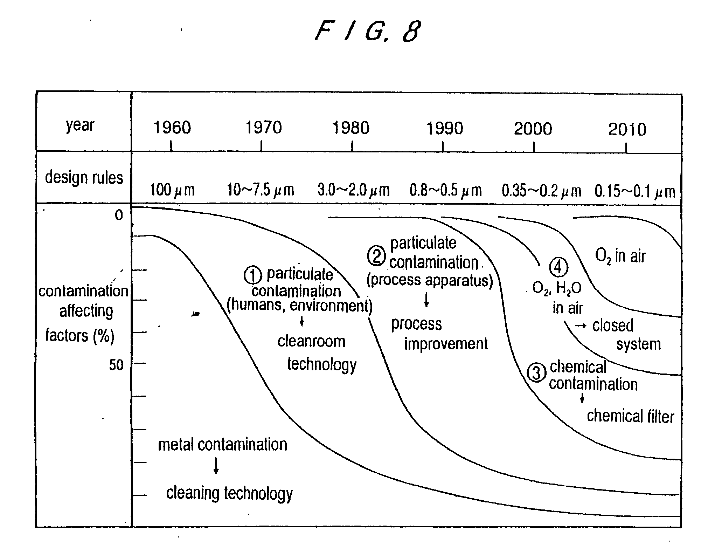

FIG. 8 shows the transition of types of contamination which are responsible for a reduction in the yield in manufacturing processes of semiconductor substrates and the trend of technologies for handling those types of contamination (cited from Ultra-clean technology, 10(1), P1 (1998)). FIG. 8 indicates that a reduction in the yield in the manufacture of semiconductor substrates was initially caused by particulate contamination (see ① and ② in FIG. 8), then was greatly affected by chemical contamination (contamination caused by gaseous substances) from late 1990s (see ③ in FIG. 8), and will be caused by contamination due to the formation of natural oxide films with O₂, H₂O in air, i.e., natural oxidization of substrate surfaces (see ④ in FIG. 8). The transition of types of contamination which are to be controlled is considered to occur because design rules become finer (patterns become finer) with time, i.e., products become higher in quality and precision with time.

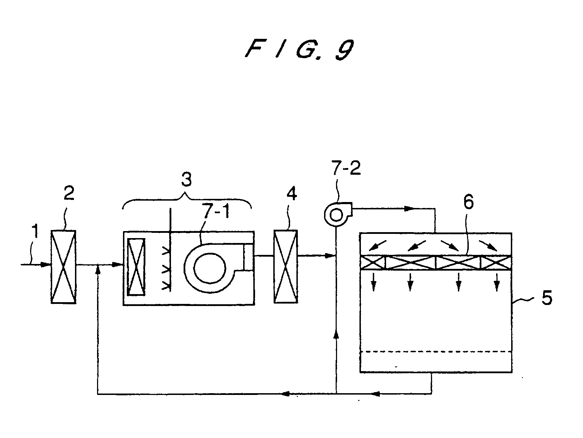

The purification of air which is achieved by the removal of fine particles (particulate substances) in cleanrooms up to now will be described below with reference to FIG. 9.

In FIG. 9, external air 1 is introduced into a pre-filter 2 which removes coarse particles therefrom, then regulated in temperature and humidity by an air-conditioning unit 3, and thereafter dedusted by a medium efficiency particulate air filter 4. Then, the air is introduced into a HEPA filter (high efficiency particulate air filter) 6 mounted on the ceiling of a cleanroom 5, which removes fine particles from the air to keep air cleanness in a class ranging from 100 to 1,000 in the cleanroom 5. The reference numerals 7-1, 7-2 represent fans, and the arrows indicate flows of air.

The system for cleaning air in the conventional cleanroom is arranged as shown in FIG. 9 because it serves the purpose of removing fine particles from air. While the system is effective in removing fine particles from air, it is not effective to remove gaseous harmful components from air. Another problem of the large-compartment cleanroom shown in FIG. 9 is that it is too costly for cleaning air to a high level represented by a class ranging from 1 to 10.

In the future, products in the semiconductor industry will become higher in quality and precision, and not only fine particles (particulate substances) but also gaseous substances will be involved as contaminants. Specifically, as described above, though it has heretofore been sufficient to remove only fine particles from air, it will also be important to remove gaseous substances (gaseous harmful substances) from air. This is because the dust removing filter (e.g., HEPA, ULPA filters) 6 in the conventional cleanroom is capable of removing fine particles only and permits gaseous harmful substances from outside to be introduced, un-removed, into the cleanroom. Those gaseous harmful substances include, for example, exhaust gases of automobiles introduced into the cleanroom, gases called hydrocarbons (HC) due to gases degassed (emitted) from polymer products widely used as consumer products, and basic (alkaline) gases such as NH₃ and amine.

Of these gases, hydrocarbons (HC) need to be removed since an ultra-low concentration of hydrocarbons in ordinary air (indoor air and external air) serves as a gaseous harmful component and causes contamination. Recently, gases removed from polymer resins of structural materials of the cleanroom, fabrication apparatus, and devices used therein have become problematic as a source of hydrocarbons (HC).

Gaseous substances which are produced by processes performed in the cleanroom are also problematic. Specifically, gaseous substances produced in the cleanroom are added to gaseous substances introduced from outside of the cleanroom (gaseous substances in the external air are introduced into the cleanroom as they cannot be removed by the particle removal filters associated with the cleanroom), so that the gaseous substances in the cleanroom are higher in concentration than those in the external air, possibly contaminating semiconductor substrates.

When contaminants (fine particles and gaseous harmful components) are applied to the surface of a semiconductor substrate, the fine particles bring about open and short circuits of circuits patterns on the substrate surface, producing defects. When hydrocarbons (HC) as gaseous substances are applied to the surface of a semiconductor substrate, they increase a contact angle, affecting the affinity between the substrate and a resist. When the affinity becomes poor, it adversely affects the film thickness of the resist and also adversely affects the intimate contact between the substrate and the resist. Hydrocarbons (HC) are also disadvantageous in that they cause a reduction in the withstand voltage (a reduction in the reliability) of an oxide film on the surface of the semiconductor substrate. The contact angle refers to an angle at which the surface of the semiconductor substrate is wetted by water, and represents the degree of contamination of the substrate surface. Specifically, when a hydrophobic (oily) contaminant is applied to a substrate surface, the substrate surface repels water and becomes less wettable by water, increasing its contact angle with respect to water droplets. Therefore, as the contact angle is greater, the degree of contamination is higher, and as the contact angle is smaller, the degree of contamination is lower.

NH₃ produces ammonium salt, and causes fogging (poor resolution) on a semiconductor substrate. For the reasons described above, these gaseous contaminants as well as the fine particles tend to lower the productivity (yield) of semiconductor products.

In particular, because the above gaseous substances as gaseous harmful components are produced as described above, and recently much air is circulated in the cleanroom for the purpose of saving energy, organic gaseous substances in the cleanroom are concentrated to a level considerably higher than those in the external air, and are applied to substrates and contaminate them.

More importance has been related to energy saving and cost saving technologies. A mini-environment, i.e., an enclosed local environment for isolating products from contamination sources and human beings, has been proposed as effective to advance those technologies, and it is important to carry out a technological development for such a mini-environment. For example, an effective mini-environment that is currently proposed for the delivery of a semiconductor substrate is accomplished by a system for housing a substrate within a closed container of transparent (light-transmissive) plastic such as polycarbonate (PC) thereby to prevent the substrate from being contaminated by cleanroom air and human beings.

However, it has been pointed out that the system using plastic containers has to meet technological needs such as for taking countermeasures against gases emitted from container materials and dust particles unexpectedly produced in the containers, and periodically cleaning the containers. The inventors of the present invention have found that local cleaning is effective to provide a mini-environment, and have proposed processes for cleaning various spaces using photo-electrons and photo-catalysts for such local cleaning applications.

For example, 1) processes of cleaning a space with photo-electrons (removing particulate substances) are disclosed in Japanese patent publications Nos. 3-3859, 6-74909, 8-211, and 7-121367, etc.
2) Processes of cleaning a space with a photo-catalyst (removing gaseous harmful components) is disclosed in Japanese laid-open patent publication No. 9-168722 and Japanese patent No. 2991963, etc.
3) Processes of cleaning a space with photo-electrons and a photo-catalyst (simultaneously removing particles and gases) are disclosed in Japanese patent No. 2623290, etc.

These disclosed processes are proposals regarding contamination with particles and/or gaseous substances (proposals for removing contaminants), and can be used in applications (apparatuses) where particles and gaseous substances pose problems.

In the future, as described above, the generation of a natural oxide film on a substrate surface will become problematic. Specifically, when a semiconductor substrate is housed in a polycarbonate container, a natural oxide film is generated on the surface of the semiconductor substrate. A natural oxide film is considered to be a very thin oxide film that is produced on the surface of a substrate such as of silicon which is a semiconductor by contact with air and water at a normal temperature. Since the natural oxide film is a thin film of insulator, it gives different properties to the base of silicon, and is treated as a contaminant. Depending on the type of various processes required for semiconductor fabrication, such a natural oxide film may sometimes cause drawbacks as with the above organic contamination. Specifically, a natural oxide film tends to adversely affect the controllability of the thickness of extremely thin gate oxide films, impair silicide reactions, increase contact resistance, and impair epitaxial growth.

The growth of a natural oxide film may be suppressed by storing a semiconductor substrate in a vacuum or in an inactive gas such as an N₂ gas or the like. However, it is troublesome and needs an extra facility cost to create a vacuum or inactive gas atmosphere each time a semiconductor substrate being processed in the semiconductor fabrication process is to be temporarily stored or fed. In addition, developing an inactive gas atmosphere poses a problem on the safety of operation in the environment.

### Disclosure of Invention

The present invention has been made in view of the above problems. It is an object of the present invention to provide a method of and an apparatus for preventing a substrate from being oxidized to suppress the production of a natural oxide film in an ordinary air atmosphere.

To achieve the above object, according to the present invention, there is provided a method of preventing the surface of a substrate from being oxidized, characterized by storing the substrate in a light-shielded closed space to suppress the growth of a natural oxide film on the substrate.

Since a semiconductor substrate is stored in the space surrounded by the light-shielding member, no light is applied to the surface of the semiconductor substrate, thus suppressing the generation of a natural oxide film. This method is capable of suppressing the generation of a natural oxide film easily at a low cost without using a vacuum or inactive gas atmosphere because the process can be performed within air.

In the space, it is preferable to store the substrate while removing a gaseous contaminant or both a gaseous contaminant and a particulate substance. It is thus possible to prevent contamination with an organic gas or both an organic gas and a particulate substance, and also to effectively suppress the production of a natural oxide film. Consequently, contamination can be prevented practically effectively.

According to the present invention, there is provided an apparatus for preventing the surface of a substrate from being oxidized, characterized by a closed space for storing the substrate and a light-shielded outer wall surrounding the space. The apparatus should preferably further include a means for removing a gaseous contaminant or both a gaseous contaminant and a particulate substance in the space. The space should preferably be provided in a clean box for delivering or storing a semiconductor substrate or in a delivery space. The semiconductor substrate can thus be stored or delivered while easily preventing a natural oxide film from being formed on the surface of the semiconductor substrate and also generally eliminating the effect of contaminants (preventing contamination from a gaseous substance and a particulate substance).

### Brief Description of Drawings

FIG. 1 is a schematic view of an apparatus for preventing a substrate from being oxidized which is installed in a cleanroom, according to an embodiment of the present invention;
FIG. 2 is a vertical cross-sectional view of a modification of the oxidization preventing apparatus;
FIG. 3 is a vertical cross-sectional view of another modification of the oxidization preventing apparatus;
FIG. 4 is a vertical cross-sectional view of still another modification of the oxidization preventing apparatus;
FIG. 5 is a vertical cross-sectional view of yet another modification of the oxidization preventing apparatus;
FIG. 6 is a graph showing that the thickness of a natural oxide film varies with time;
FIGS. 7A through 7D are views showing light shielding members by way of example;
FIG. 8 is a diagram showing various types of contamination and their transition in semiconductor fabrication processes; and
FIG. 9 is a view showing a system for cleaning air in a conventional cleanroom.

### Best Mode for Carrying Out the Invention

The present invention has been made based on the following four findings with respect to a cleanroom which is used in the fabrication of semiconductor products or the like.
(1) As shown in FIG. 8, contamination of substrates such as semiconductor substrates was heretofore mainly caused by the deposition of fine particles, and has recently been greatly affected by the deposition of gaseous substances. In the future, it will be important to control (prevent) the generation of a natural oxide film on the substrate surface.
   Specifically, as devices become finer in the future, it will be more important to perform structural control over silicon surfaces in an atomic scale. Since natural oxide films tend to adversely affect the controllability of the thickness of extremely thin gate oxide films, impair silicide reactions, increase contact resistance, and impair epitaxial growth, a control technology for controlling natural oxide films will be required in the future.
(2) The generation of a natural oxide film on a substrate surface is affected by light (e.g., visible light emitted from a fluorescent lamp) in a cleanroom. Therefore, shielding the substrate against visible light, i.e., placing the substrate in a light-shielded box, is effective to prevent the substrate from being oxidized. The generation of a natural oxide film on a substrate surface is affected by light including an infrared radiation having a wavelength of 1,500 nm.
(3) It will be important to establish mini-environments in cleanrooms from energy saving and cost saving standpoints. Specifically, a substrate is prevented from being contaminated by placing the substrate in a box of plastic to isolate the substrate from cleanroom air and human beings.
   At present, a system for housing a substrate in a box of plastic (e.g., polycarbonate) and delivering same is considered as an effective way to establish a mini-environment. However, the box is light-transmissive, and emits phthalic acid ester (gas) such as DOP or DBP. The emitted gas itself is attached to a semiconductor substrate, and not only adversely affects the semiconductor substrate (lowers the yield of the product), but also acts to promote oxidization of the substrate surface. Therefore, it is important in semiconductor substrate fabrication processes to shield substrates from light under (2) and to remove organic gases or both organic gases and particulate substances under (3) depending on required specifications. Specifically, since the removal of particulate substances having particle sizes ranging from 1 to 10 nm, for example, which have heretofore been not problematic, will be important depending on applications (apparatus types), such particulate substances need to be removed depending on the required performance.
(4) It is effective to remove organic gases according to a trapping/removing process using an adsorbent and a decomposing/treating process using a photo-catalyst.

Therefore, embodiments of the present invention are classified into the following two embodiments:

According to a first embodiment, the outer wall of a box or a space for storing or delivering a semiconductor substrate as described later on is made of light-shielding material. This embodiment is preferably applicable to a case where the staying (storage) time of a substrate in the above box or space is short, normally a few hours, and is preferable if the outer wall of the box or the space is made of a material of low gas emission.

According to a second embodiment, the outer wall of a box or a space for storing or delivering a semiconductor substrate as described later on is made of light-shielding material, and the box or the space houses therein a unit for removing organic gases or a unit for removing organic gases and particulate substances. This embodiment is preferably applicable to a case where the staying or storage time of substrates in the above box or space is long, e.g., 12 hours or a few days or more. The light to be blocked has a wavelength of 1,500 nm (near-infrared) or shorter or preferably a wavelength of 750 nm (visible light) or shorter.

The light is blocked to a level of 10 lux or lower, preferably 5 lux or lower, or more preferably 1 lux or lower, which may be reviewed and determined depending on the type and required performance of the apparatus.

Various structural details of the present invention will be described below.

A box or space according to the present invention serves to house, delivery, and/or store a substrate and its outer wall may be made of any material insofar as it can shield the substrate from light. For example, the outer wall material is made of metal or synthetic resin. If the outer wall is made of metal, then it is preferably made of aluminum or stainless steel. However, the outer wall of aluminum is preferable as it is lightweight. If the outer wall is made of synthetic resin, then it is preferably made of a material of excellent machinability, rigidity, and durability, with low gas emission, and more preferably with a light blocking capability. For example, a general plastic such as ABS, acrylic resin, or the like, an engineering plastic such as polycarbonate (PC) or the like, or a super-engineering plastic such as poly-ether imide or the like is preferable. The outer wall of synthetic resin is practically preferable as it is lighter and more inexpensive than the outer wall of metal.

Transparent materials such as polycarbonate may be modified or processed into light-shielding materials according to processes (1), (2) below, so that they can preferably be used as the outer wall material.
(1) Process of mixing a filler:
   When a box or the like is made of a transparent resin material, it can be turned into a light-shielding material by being mixed with a light-absorbing material. The material that can be mixed may be carbon, calcium carbonate, magnesium hydroxide, iron oxide, dye, or the like. Of these materials, carbon is preferable depending on the application as it is effective to remove (neutralize) the potential of the substrate.
(2) Process of coating (adding) a light-shielding material on a container wall surface:
   A container of a transparent material can be turned into a light-shielding container by coating the wall surface of the container with a light-shielding material. For example, the wall surface of the container may be coated with a metal such as Al, Ag, Cr, Si, Ti, Ni, W, Co, or the like by sputtering or evaporation.

Of these materials, Ti is preferable if applied as TiO₂ depending on the application as it has a photo-catalytic action as described later on (an action of absorbing external light and decomposing and making hydrocarbons harmless on inner surfaces).

The process of coating a wall surface with a light-shielding material is also preferable as the applied light-shielding material is capable of preventing (suppressing) the emission of a gas from the wall surface (material). One of the above processes may be selected by conducting a preliminary analysis (test) depending on the type of the material, required performance, economy, etc. of the box or the space.

The unit for removing organic gases will be described below.

The unit comprises a device for removing organic gases contained in the box or the space for thereby effectively preventing the surface of the substrate from being oxidized.

Specifically, the box or the space contains a higher concentration of organic gases than cleanroom air due to organic gases contained in air introduced into the cleanroom, organic gases emitted from the material of the box or the space, and organic gases emitted from the surface of the substrate stored (delivered) in the box or the space, thus promoting oxidization of the substrate surface. The unit removes such organic gases, thereby preventing the surface of the semiconductor substrate from being contaminated with organic deposits and increasing an ability to prevent a natural oxide film from being deposited on the substrate surface.

Organic gases can be removed by an adsorbent and/or a photo-catalyst. Each of these substances will be described below.

The adsorbent may be any material insofar as it can efficiently trap and remove organic gases in the box or the space, in particular, hydrocarbons (HC) having a large adhesion (adsorption) capability with respect to substrates, e.g., hydrocarbons (HC) having - CO -, - COO - groups, e.g., phthalic acid ester. Such adsorbent materials include activated carbon, zeolite, alumina, silica gel, glass, fluoride compound, metal, polymeric compound (styrene polymer), etc. Of these adsorbent materials, activated carbon is preferable as it is effective in the above application. Activated carbon may be of a particulate shape, a fibrous shape, a net-like shape, or a honeycomb shape. The fibrous shape is preferable as it causes a low pressure loss depending on the type and use of the unit. In using the adsorbent, humidity in the gas to be processed should preferably be removed (dehumidified) because removing water from the gas increases the performance (service life) of the adsorbent. The gas may be dehumidified according to an electronic dehumidifying process, a cooling coil process, or an adsorbing process using silica gel, zeolite, activated alumina, magnesium perchlorate, or calcium chloride. One of the above processes may be selected by conducting a preliminary test depending on the application, required performance, etc.

The photo-catalyst will be described below.

The photo-catalyst may be any material insofar as it can be excited by being irradiated with light and can decompose hydrocarbons (HC), etc. which tend to be applied to semiconductor substrates, as described above. The ability of the photo-catalyst to decompose hydrocarbons (HC) on substrates such as wafers having a hydrophilic surface may be such that it can convert organic gases (non-methane hydrocarbons) involved to increase the contact angle into a form not involved to increase the contact angle or into a stable form which does not affect the substrate even when it is applied to the substrate.

The photo-catalyst is preferably made of semiconductor materials, shown below, as they are effective, easily available, economic, and well machinable. Specifically, the photo-catalyst may be made of any one of Se, Ge, Si, Ti, Zn, Cu, Al, Sn, Ga, In, P, As, Sb, C, Cd, S, Te, Ni, Fe, Co, Ag, Mo, Sr, W, Cr, Ba, and Pb, or a compound thereof, an alloy thereof, or an oxide thereof, either singly or in a compound of two or more.

For example, elements that can be used include Si, Ge, and Se, compounds that can be used include AlP, AlAg, GaP, AlSb, GaAs, InP, GaSb, InAs, InSb, CdS, CdSe, ZnS, MoS₂, WTe₂, Cr₂Te₃, MoTe, Cu₂S, and WS₂, oxides that can be used include TiO₂, Bi₂O₃, CuO, Cu₂O, ZnO, MoO₃, InO₃, Ag₂O, PbO, SrTiO₃, BaTiO₃, Co₃O₄, Fe₂O₃, and NiO. Depending on the application, a metal may be baked, and a photo-catalyst may be formed on the surface of the baked metal. For example, a photo-catalyst is produced by baking Ti at 1000°C and forming TiO₃ on the surface of the baked Ti (see Japanese patent application No. 9-273302).

For improving the photo-catalyst action, a substance such as Pt, Ag, Pd, RuO₂, or Co₃O₄ may be added to the photo-catalyst. The addition of the substances is preferable because it promotes the action of the photo-catalyst to decompose hydrocarbons (HC). These substances may be used singly or in combination. Usually, the added amount of these substances ranges from 0.01 weight % to 10 weight % with respect to the photo-catalyst. A proper concentration of the added substance or substances may be selected by conducting a preliminary test depending on the type of the added substance or substances, required performance thereof, etc. The substance or substances may be added to the photo-catalyst by a known process such as impregnation, photo-reduction, sputtering evaporation, kneading, etc.

The photo-catalyst may be installed in position by being fixed in a flow of air, fixed to a wall surface, or suspended in air.

The photo-catalyst may be fixed in the unit by being applied to, enclosed in, or sandwiched by a plate-like material, a cotton-like material, a fibrous material, a net-like material, a honeycomb material, a membrane material, or a sheet-like material. For example, the photo-catalyst may be applied to a ceramic material, a fluoro-plastic material, or a glass material by a known applying process such as a sol-gel process, a baking process, an evaporation process, a sputtering process, or the like. Generally, the fibrous, net-like, or honeycomb shape is preferable as they cause a low pressure loss.

One example is the application of TiO₂ to glass fiber according to the sol-gel process. The process of applying the photo-catalyst to the surface of a light-transmissive filamentary product, which has been proposed by the inventor (Japanese laid-open patent publication No. 7-256089), may also be used. The integration with a light source, which has been proposed by the inventor (Japanese patent No. 2991963) may also be used.

Any light source may be used to apply light to the photo-catalyst insofar as the photo-catalyst provides a photo-catalytic action when irradiated with light from the light source. Specifically, a hydrocarbon (HC) can be decomposed by a photo-catalytic action when a gas being processed is brought into contact wit the photo-catalyst while the photo-catalyst is being irradiated with light in a light absorption range (wavelength range) determined depending on the type of the photo-catalyst.

Main light absorption ranges of photo-catalyst materials are shown below.

Si: < 1,100 (nm), Ge: 1,825 (nm), Se: < 590 (nm), AlAs: 517 (nm), Alsb: < 827 (nm), GaAs: 886 (nm), InP: < 992 (nm), InSb: 6,888 (nm), InAs: < 3,757 (nm), CdS: < 520 (nm), CdSe: < 730 (nm), MoS₂: < 585 (nm), ZnS: < 335 (nm), TiO₂: < 415 (nm), ZnO: < 400 (nm), Cu₂O: < 625 (nm), PbO: < 540 (nm), Bi₂O₃: < 390 (nm).

The light source may be of known nature insofar as it has a wavelength in the light absorption range of the photo-catalyst, and may comprise sunlight or an ultraviolet lamp. Ultraviolet sources that can be used include a mercury lamp, a hydrogen discharge lamp, a xenon discharge lamp, a Lyman discharge lamp, etc. Examples of the light source that can be used are a sterilizing lamp, a black light, a fluorescent chemical lamp, a UV-B ultraviolet lamp, a xenon lamp, etc.

Of these lamps, the sterilizing lamp (main wavelength: 254 nm) is preferable as it can increase its effective dose that is applied to the photo-catalyst for increasing a photo-catalytic action, has a sterilizing action, is ozone-less, can easily be installed, is inexpensive, can easily be maintained, managed, and kept at a desired working level, and is of high performance.

The dose of the light source which is applied to the photo-catalyst is in the range from 0.05 to 50 mW/cm², or preferably 0.1 to 10 mW/cm².

In using the photo-catalyst, it is important to prevent light from the light source from being applied to the substrate in the box or the space. Therefore, the unit (shape, structure) has a light-shielding member for blocking light from the light source against application to the photo-catalyst.

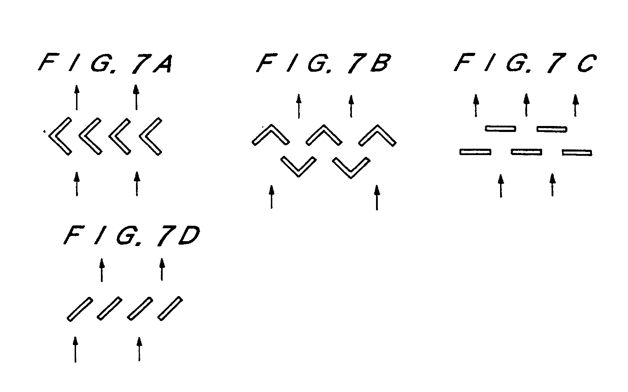

Light from the light source can be blocked by a light-shielding member shaped to block the light that travels straight, which is positioned above or below the light source in the unit. FIGS. 7A through 7D show examples of the light-shielding member thus shaped. In FIGS. 7A through 7D, the arrows indicate the direction of an air flow. The light-shielding member may be made of any material insofar as it can be machined to the above shape, and should preferably be made of a material with small light reflectance or a light-absorbing material. Examples of the material of the light-shielding member include ZnO₂, TiO₂, NiP, C (Carbon black), and metal black. Of these materials, TiO₂ has an ability to decompose hydrocarbons (HC) as described above, and hence is preferable depending on the application and the required performance.

For controlling (removing) contaminants on the substrate surface in thecleanroom, importance is also attached to fine particles (particulate materials). Fine particles may be removed by a combination of various known means. One fine particle removing means includes any dust removing filter capable of efficiently trapping fine particles (particulate materials) in cleanrooms to a low concentration. Usually, a HEPA filter, an ULPA filter, and an electrostatic filter are preferable as they are simple and effective. It is also preferable to use a dehumidifying material for removing humidity.

Furthermore, processes using photo-electrons (UV/photo-electron processes disclosed in Japanese patent publications Nos. 6-74909, 7-121369, 8-211, and 8-22393, and Japanese patent No. 2623290) proposed by the inventors may also be used.

If organic gases are removed using the photo-catalyst, then fine particles should preferably be removed according to the UV/photo-electron process depending on the applied conditions and the required performance because light used by the photo-catalyst can also be used in the UV/photo-electron process and hence the apparatus used may be simplified.

Cleaning air through the removal of fine particles with photo-electrons will be described below.

A process of cleaning air with photo-electrons is carried out by a photo-electron emitter, an ultraviolet lamp, an electrode for developing an electric field for photo-electron emission, and a charged fine particle trap, to remove fine particles (particulate materials).

The photo-electron emitter may be made of any material insofar as it is capable of emitting photo-electrons in response to ultraviolet irradiation, and should preferably be made of a material having a lower photoelectric work function. From the standpoints of effectiveness and economy, the photo-electron emitter should preferably be made of any one of Ba, Sr, Ca, Y, Gd, La, Ce, Nd, Th, Pr, Be, Zr, Fe, Ni, Zn, Cu, Ag, Pt, Cd, Pb, Al, C, Mg, Au, In, Bi, Nb, Si, Ti, Ta, U, B, Eu, Sn, P, W, or a compound thereof, an alloy thereof, or a mixture thereof, either singly or in a compound of two or more. If a compound is used, it may be a physical compound such as an amalgam.

Compounds as materials of the photo-electron emitter include oxides, borides, and carbides, for example. Oxides include BaO, SrO, CaO, Y₂O₅, Gd₂O₃, Nd₂O₃, ThO₂, ZrO₂, Fe₂O₃, ZnO, CuO, Ag₂O, La₂O₃, MgO, In₂O₃, BiO, NbO, BeO, etc. Borides include YB₆, GdB₆, LaB₅, NdB₆, CeB₆, EuB₆, PrB₆, ZrB₂, etc. Carbides include UC, ZrC, TaC, TiC, NbC, WC, etc.

Alloys as materials of the photo-electron emitter include brass, bronze, phosphor bronze, an alloy of Ag and Mg (with 2 to 20 wt % of Mg), an alloy of Cu and Be (with 1 to 10 wt % of Be), and an alloy of Ba and Al. Of these alloys, an alloy of Ag and Mg, an alloy of Cu and Be, or an alloy of Ba and Al is preferable. The oxides may be produced by heating only a metal surface in air or oxidizing it with a chemical.

According to another process, a metal surface may be heated, prior to use, to form an oxide layer thereon which will remain stable for a long period of time. As an example, an alloy of Mg and Ag is heated in a water vapor at a temperature ranging from 300 to 400°C to form an oxide layer thereon, which is stable for a long period of time.

A substance capable of emitting photo-electrons may be added to another substance. For example, a substance capable of emitting photo-electrons is added to an ultraviolet transmitting substance (Japanese patent publication No. 7-93098 and Japanese patent No. 3046085).

The photo-electron emitter may be integrated with an ultraviolet source, e.g., added to the surface of an ultraviolet lamp (Japanese patent No. 3046085). Since the photo-electron emitter integrated with an ultraviolet source results in a compact structure, this approach is preferable depending on the box that is applied.

The photo-electron emitter may also be integrated with the photo-catalyst (e.g., TiO₂ as described later on) (Japanese laid-open patent publication No. 9-294919). This form is preferable depending on the application (the type of the apparatus and the required performance thereof) because the photo-catalyst can stabilize the photo-electron emitter for a long period of time (i.e., the photo-catalyst can remove a substance that affects the photo-electron emitter) and can remove coexisting gaseous contaminants.

The photo-electron emitter may be shaped and structured differently depending on the shape, structure, or desired effect of the apparatus (cleaning unit).

The irradiation source for enabling the photo-electron emitter to emit photo-electrons may be any source insofar as it can emit photo-electrons upon irradiation, and should usually be an ultraviolet source.

Ultraviolet rays emitted from the irradiation source may be of any types insofar as the photo-electron emitter can emit photo-electrons in response to being irradiated with the ultraviolet rays.

The ultraviolet source may be any ultraviolet source insofar as it can emit ultraviolet radiation, and should preferably comprise a mercury lamp, e.g., a sterilizing lamp, for its compactness.

The positions and shapes of the ultraviolet source, the photo-electron emitter, the electrode, and the charged fine particle trap, according to a feature of the present invention, will be described below. The photo-electron emitter, the electrode, and the charged fine particle trap, together with the photo-catalyst described later on, are installed in surrounding relation to the ultraviolet source, and are integrally combined with each other as a unit apparatus for cleaning gases including organic gases and fine particles.

The photo-electron emitter may be positioned and shaped in any way insofar as it surrounds the ultraviolet radiation emitted from the ultraviolet source (so as to provide a wide irradiation area). Inasmuch as the ultraviolet radiation from the ultraviolet source is emitted radially across a circumferential direction, the photo-electron emitter may be positioned and shaped in any way insofar as it is installed circumferentially in surrounding relation to the ultraviolet radiation.

The photo-electron emitter can emit photo-electrons effectively when irradiated with ultraviolet radiation in an electric field. The electrode for developing such an electric filed may be positioned and shaped in any way insofar as it can develop an electric field between itself and the photo-electron emitter. The electrode may be made of such a material and may be of such a structure which are used in known charging apparatus. The electrode may be made of any conductors including tungsten, SUS, and Cu-Zn in the form of wires, rods, nets, and plates. One or more of these materials and shapes are combined and installed to develop an electric field in the vicinity of the photo-electron emitter (Japanese laid-open patent publication No. 2-303557).

The trap (dust collector) for trapping charged fine particles generally comprises a dust collecting plate used in usual charging apparatus, any of various electrodes such as duct collecting electrodes, or an electrostatic filter. However, a wool-like electrode such as a steel wool electrode or a tungsten wool electrode may also be effective as the trap. An electret may also preferably be used.

A preferable combination of the photo-electron emitter, the electrode, and the trap may be determined depending on the shape, structure, required performance, and economy of the local space (the space to be cleaned), and may be such that contaminants such as fine particles existing in the space to be cleaned can quickly move into the unit that is installed in the space.

The positions and shapes of the photo-electron emitter and the electrode may be determined by a preliminary test in view of the shape, effect, economy, etc. of the box so that the photo-electron emitter and the electrode surround the ultraviolet source, that the ultraviolet source, the photo-electron emitter, the electrode, and the trap are integrated with each other, that the ultraviolet radiation emitted from the ultraviolet source can effectively be utilized, and that photo-electrons can effectively be emitted and fine particles can effectively be charged and trapped by the photo-electrons. For example, if a rod-shaped (cylindrical) ultraviolet lamp is used, then since ultraviolet radiation is emitted radially across the circumferential direction, the amount of emitted photo-electrons becomes greater as the radially emitted ultraviolet radiation is applied to the photo-electron emitter as much as a possible.

In the cleanroom, various substances can be a contamination source depending on the process and the substrate. For example, alkaline substances such as NH₃ and acid substances such NOx, SOx, HF, HCI, etc. may also be problematic in addition to the organic gases referred to above. In such a case, a combination of known traps (removers) for removing alkaline substances and acid substances may be used. Such traps may be made of ion-exchange fiber (filter) or activated carbon (acid- or alkali-coated carbon).

Details of the suppression of the generation of a natural oxide film by blocking light are unknown, but may be considered as follows: When light is applied, light having an energy greater than the band gap generates electrons and holes which serve to promote the formation of a natural oxide film. Accordingly, when such light is blocked, the generation of a natural oxide film is expected as being suppressed.

### [Embodiments]

Embodiments of the present invention will be described below. However, the present invention is not limited to the embodiments described below.

### [Embodiment 1]

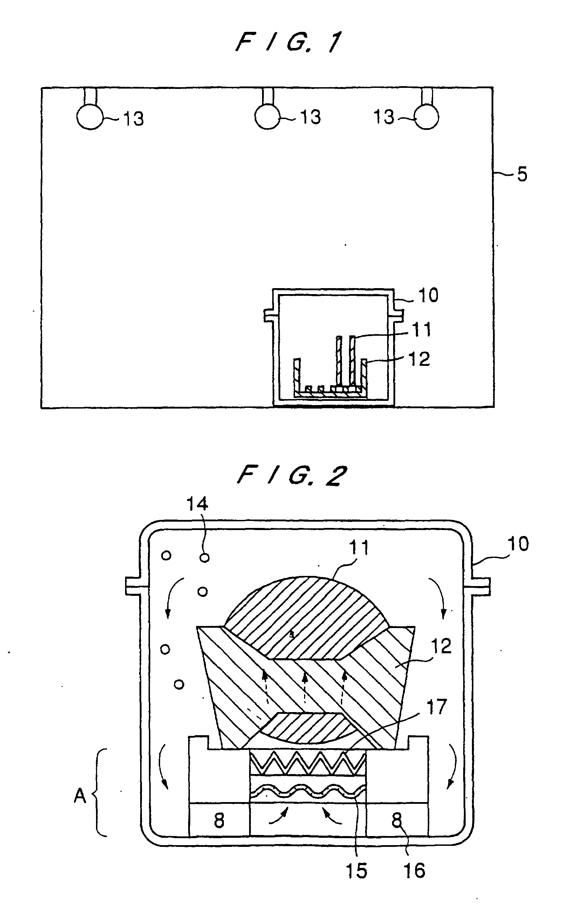

FIG. 1 shows a carrier box according to the present invention for storing or delivering semiconductor substrates for use in a cleanroom. The carrier box 10 is used to carry semiconductor substrates in a local, highly cleaned zone of class 10 within a cleanroom 5 in a semiconductor factory of class 1000. Semiconductor substrates 11 are prevented from being oxidized within the box 10, i.e., the generation of a natural oxide film on those semiconductor substrates 11 is suppressed.

In FIG. 1, the carrier box 10 is made of a wall (box) material having a light blocking capability, and the semiconductor substrates 11 are stored in a carrier 12 within the carrier box 10.

Air essentially free of fine particles of class 10 is sealed within the carrier box 10, and contains hydrocarbons (HC) introduced from outside of the cleanroom 5 and additionally contains 0.8 to 1.1 ppm of hydrocarbons (HC) emitted from materials of the cleanroom and devices therein.

Light (visible light and ultraviolet radiation) is emitted from illuminating lamps 13 mounted on the entire ceiling of the cleanroom 5 and disposed in the cleanroom 5. Since the semiconductor substrates 11 are shielded from the light by the light-shielding box material, any natural oxide film deposited on the semiconductor substrates 11 in the carrier box 10 is suppressed to a thickness of 0.02 Å or less.

After having been stored in the carrier box 10, the semiconductor substrates 11 are delivered to a next process (fabrication process) usually within 5 hours. The carrier box 10 is made of a plastic material of low gas emission, developed by the present inventors, which emits a less gas than polycarbonate). A thin film of Al is added to the wall surface of the carrier box 10 by sputtering, thus enabling the carrier box 10 to block light.

The cleanroom 5 is illuminated at about 500 lux. The illuminance within the carrier box 10 is of about 5 lux or lower.

### [Embodiment 2]

FIGS. 2 through 5 show a modification of the semiconductor substrate carrier box 10 in the cleanroom 5 according to Embodiment 1, the modification having a unit for removing organic gases.

The carrier box 10 for carrying semiconductor substrates as shown in FIGS. 2 through 5 is suitable for storing semiconductor substrates 11 in the carrier box 10 for a long period of time (e.g., for a few days). Specifically, if the storage time becomes longer, then the semiconductor substrates 11 are contaminated by organic gases 14 in the carrier box 10, accelerating oxidization on the semiconductor substrates 11. Thus, the carrier box 10 has an organic gas removal unit A for removing the organic gases in the carrier box 10. In FIGS. 2 through 5, the arrows indicate flows of air, and identical reference numerals designate identical parts.

Each of FIGS. 2 through 5 will be described below.

FIG. 2 shows a semiconductor substrate carrier box 10 whose wall material is capable of blocking light, with an organic gas removal unit A using an adsorbent. The unit A comprises an activated carbon 15 as a hydrocarbon (HC) remover, a fan 16 for passing processing air, and a HEPA filter 17 for removing produced duct. In the carrier box 10, there exist 0.8 to 1.1 ppm of hydrocarbons (HC) containing in the cleanroom air that enters each time the semiconductor substrates 11 stored in the carrier 12 are loaded into and unloaded from the carrier box 10, and hydrocarbons (HC) 14 as gases emitted from the materials of the carrier box 10 and the semiconductor substrate carrier 12. The unit A traps and removes the hydrocarbons (HC) to a concentration of 0.1 ppm or lower. Fine particles are also trapped and removed by the filter 17 to a level of class 1 or lower.

Since the carrier box 10 has a light-blocking capability, it blocks light emitted from the illuminating lamps 13 in the cleanroom 5, with the result that any natural oxide film generated on the semiconductor substrates 11 stored in the carrier box 10 is suppressed to a thickness of 0.02 Å or less.

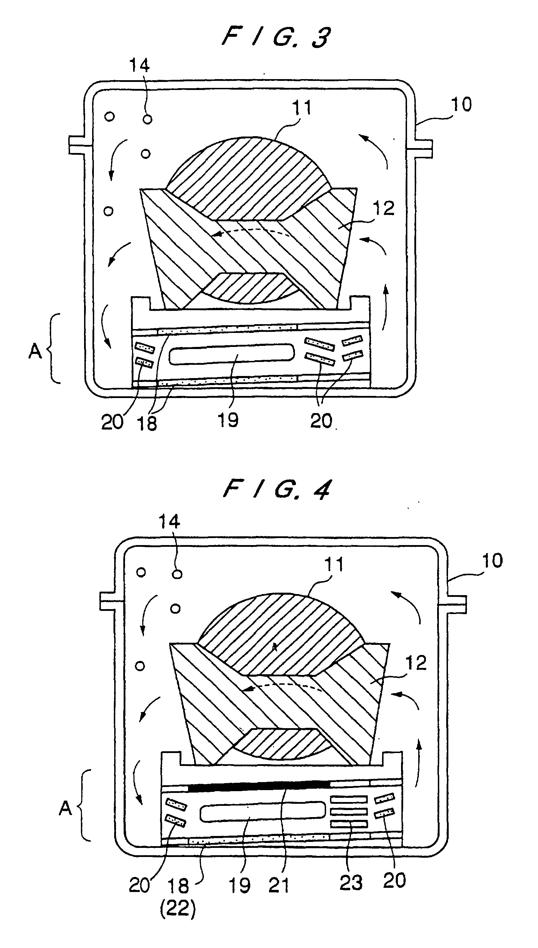

FIG. 3 shows a semiconductor substrate carrier box 10 whose wall material is capable of blocking light, with an organic gas removal unit A using a photo-catalyst. The unit A comprises a photo-catalyst (TiO₂) 18 as a hydrocarbon (HC) remover, an ultraviolet lamp 19 for applying ultraviolet radiation to the photo-catalyst 18, and a light-shielding member 20 for blocking light from the ultraviolet lamp (black light). In the carrier box 10, there exist 0.8 to 1.1 ppm of hydrocarbons (HC) contained in the cleanroom air that enters each time the semiconductor substrates 11 stored in the carrier 12 are loaded into and unloaded from the carrier box 10, and hydrocarbons (HC) 14 which are gases emitted from the materials of the carrier box 10 and the semiconductor substrate carrier 12. The unit A decomposes and removes the hydrocarbons (HC) to a concentration of 0.1 ppm or lower. In the box 10, specifically, hydrocarbons (HC) in the box are carried to the unit A by air flows (indicated by the arrows) generated by the heat from the ultraviolet lamp 19, and decomposed and removed (hydrocarbons (HC) are self-cleaned away). Since the carrier box 10 has a light-blocking capability, it blocks light emitted from the illuminating lamps 13 in the cleanroom 5, and removes hydrocarbons (HC). Consequently, with semiconductor substrates stored in the carrier box 10, no gaseous concentrated substances are deposited on the semiconductor substrates 11, and any natural oxide film generated on the semiconductor substrates 11 stored in the carrier box 10 is suppressed to a thickness of 0.02 Å or less.

FIG. 4 shows a photo-electron emitter 21, an electrode 22 (integrated with the photo-catalysts 18) for emitting photo-electrons, and a charged fine particle trap 23, which are added to the unit A shown in FIG. 3, for removing fine particles in addition to hydrocarbons (HC) shown in FIG. 3. With this arrangement, it is possible to remove hydrocarbons (HC) to a concentration of 0.1 ppm or lower and fine particles to class 1 or lower.

Specifically, because the carrier box 10 provides a highly clean space by simultaneously removing particles and gaseous contaminants, when semiconductor substrates are stored in the carrier box 10, both particles and gaseous contaminants are not deposited on the semiconductor substrates, and any natural oxide film generated on the semiconductor substrates 11 is suppressed to a thickness of 0.02 Å or less.

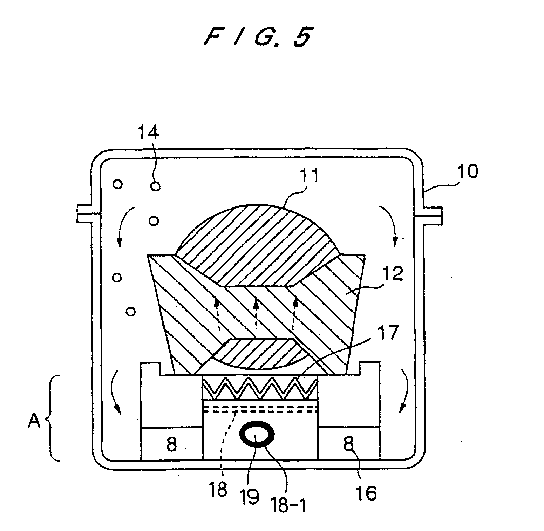

FIG. 5 shows photo-catalysts 18, 18₋₁ that are used to remove hydrocarbons (HC) in the unit A shown in FIG. 2. Specifically, the photo-catalyst 18 comprises a net-like photo-catalyst disposed in an air passage, and the photo-catalyst 18₋₁ comprises a coating on the surface of the ultraviolet lamp 19. When the photo-catalysts 18, 18₋₁ are irradiated with ultraviolet radiation from the ultraviolet lamp 19, they perform a photo-catalytic action to remove (decompose) hydrocarbons (HC). With this arrangement, it is possible to remove hydrocarbons (HC) to a concentration of 0.1 ppm or lower and fine particles to class 1 or lower.

Specifically, because the carrier box 10 provides a highly clean space by simultaneously removing particles and gaseous contaminants, when semiconductor substrates are stored in the carrier box 10, both particles and gaseous contaminants are not deposited on the semiconductor substrates, and any natural oxide film generated on the semiconductor substrates 11 is suppressed to a thickness of 0.02 Å or less.

The semiconductor substrate carrier boxes 10 shown in FIGS. 2 through 5 are made of polycarbonate, and are made capable of blocking light by adding 2 % of a pigment to polycarbonate when they are manufactured. The illuminance in these boxes is of 5 lux or less.

### [Embodiment 3]

Sample air, described below, was introduced into semiconductor substrate carrier boxes storing 8-inch semiconductor substrates shown in FIGS. 1 through 3, and the semiconductor substrate carrier boxes were placed in a cleanroom with light turned on therein. Then, natural oxide films on the surfaces of semiconductor substrates, contact angles on the semiconductor substrates, and the concentrations of non-methane hydrocarbons (HC) in the carrier boxes were measured.
(1) The size of the carrier boxes: about 20 liters.
(2) The carrier boxes:
   ① FIG. 1: The inner surface of the box of polycarbonate was coated with Al to 100 nm by sputtering, making the box capable of blocking light.
   ② FIGS. 2 and 3: When the boxes of polycarbonate were manufactured, 2 % of a pigment was mixed with polycarbonate, making the box capable of blocking light.
      a) The structure of the organic gas removal unit A in the box shown in FIG. 2: Activated carbon fiber, HEPA filter, fan (circulated air rate: 1 l/min.).
      b) The structure of the organic gas removal unit A in the box shown in FIG. 3: Photo-catalyst (TiO₂ was applied to quartz glass by a sol-gel process), ultraviolet lamp (black light, 4 W).
(3) Sample air: Air in a cleanroom in a semiconductor factory of class 1000, with hydrocarbons (HC) at a concentration: 0.8 to 1.2 ppm.
(4) Measurement evaluation:
   ① Thickness of a natural oxide film: High-resolution XPS, Type ESCA300, manufactured by Scienta.
   ② Contact angle: Water droplet contact angle meter, Type CA-DT, manufactured by Kyowa Interface Science.
   ③ Concentration of hydrocarbons (HC): Type 14A, manufactured by GC Shimadzu Corp.
   ④ Illuminance meter: LX-1300, manufactured by CUSTON.
(5) Pretreatment of semiconductor substrates: After RCA cleaning, semiconductor substrates are treated with HF (0.05 %), and then rinsed with pure water.

The results are shown below.

The growth of natural oxide films on semiconductor substrates is shown in Table 1.

**Table 1**

| Natural oxide films on wafers | | | | | | | |
|---|---|---|---|---|---|---|---|
| Storage time (h) | Thickness of natural oxide film (Å) | | | | | | |
| | Comparative Examples | | Box shown in FIG. 1 | Box shown in FIG. 2 | | Box shown in FIG. 3 | |
| | | | | Organic gas removal unit | | Organic gas removal unit. | |
| | Cleanroom | PC | | Yes | No | Yes | No |
| 3 | 0.3 | 0.5 | < 0.02 | < 0.02 | 0.02 | < 0.02 | 0.02 |
| 48 | 5 | 6 | < 0.02 | < 0.02 | 0.05 | < 0.02 | 0.05 |

Table 1 shows the thicknesses of natural oxide films upon elapse of 3 and 48 hours after the semiconductor substrates were stored in the boxes. In the box shown in FIG. 1, the thicknesses of natural oxide films are of 0.02 Å or less after elapse of 3 and 48 hours. In the boxes shown in FIGS. 2 and 3, the thicknesses of natural oxide films are of 0.02 Å or less after elapse of 3 and 48 hours in the presence of the organic gas removal unit. However, the thicknesses of natural oxide films are of about 0.02 Å or less after elapse of 3 hours and about 0.05 Å after elapse of 48 hours in the absence of the organic gas removal unit. When semiconductor substrates were simply left under the illumination in the cleanroom in Comparative Examples, the thicknesses of natural oxide films are of about 0.3 Å or less after elapse of 3 hours and about 5 Å after elapse of 48 hours. When semiconductor substrates were housed in a polycarbonate container and left in the cleanroom, the thickness of natural oxide films are of about 0.5 Å or less after elapse of 3 hours and about 6 Å after elapse of 48 hours. It can thus be seen that a mini-environment developed in a light-shielding container is effective to suppress the growth of a natural oxide film.

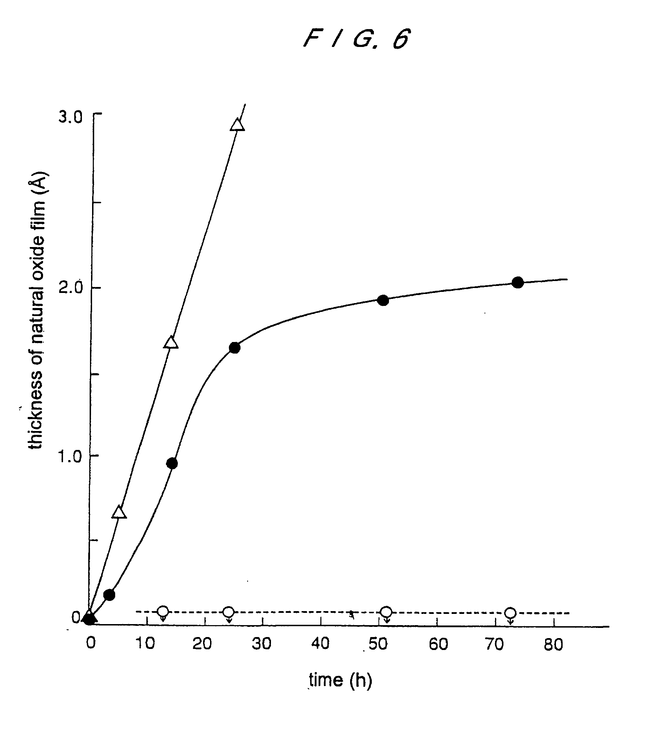

FIG. 6 shows the growth of natural oxide films under various conditions. The curve represented by ○ indicates an example in which a semiconductor substrate was stored in a polycarbonate box with a light-shielding coating according to the present invention shown in FIG. 1. In this example, the semiconductor substrate was stored for 3 hours, 12 hours, 24 hours, 50 hours, and 70 hours. The light-shielding coating substantially prevented a natural oxide film from being generated, with the thickness of any produced natural oxide film being less than a detectable limit of 0.1 Å and hence almost nil. The curve represented by • indicates an example in which a semiconductor substrate was stored in a transparent polycarbonate box. The polycarbonate box is made of a material of low gas emission. When left under the illumination in the cleanroom, the growth of a natural oxide film manifests itself up to about 24 hours, but is thereafter saturated. This appears to result from the fact that since the environment is closed, no new oxygen is supplied and the thickness of the natural oxide film remains at a certain level. The curve represented by Δ indicates an example, in which no light is turned on in the cleanroom, i.e., a semiconductor substrate is left in a light-shielded environment. In this case, a natural oxide film grows substantially linearly to a thickness of about 3 Å with time. The natural oxide film thus grows because air is abundantly present in the cleanroom, supplying fresh oxygen continuously, though the semiconductor substrate is shielded from light.

The illuminance was of 1400 lux within the cleanroom, 600 lux within the polycarbonate box, and 1 lux or lower within the polycarbonate box with the light-shielding coating.

Contact angles on the surfaces of semiconductor substrates will be described below with reference to Table 2.

**Table 2**

| Contact angles on wafers (degrees) | | | | | | |
|---|---|---|---|---|---|---|
| Comparative Examples | | Box shown in FIG. 1 | Box shown in FIG. 2 | | Box shown in FIG. 3 | |
| | | | Organic gas removal unit | | Organic gas removal unit | |
| Cleanroom | PC | | Yes | No | Yes | No |
| 18 | 25 | 5 | 4 | 18 | 4 | 18 |
| Initial value of contact angle: 4 degrees | | | | | | |

The contact angle in the box shown in FIG. 1 which was made of a material of low gas emission was 5 degrees, whereas the contact angles in the boxes shown in FIGS. 2 and 3, each having the organic gas removal unit, were 4 degrees. In the boxes each with no organic gas removal unit, the contact angles increased to about 18 degrees. When a semiconductor substrate was left in the cleanroom in Comparative Example, the contact angle was a large value of 18 degrees, and when a semiconductor substrate was stored in a closed container of polycarbonate in Comparative Example, the contact angle was a very large value of about 25 degrees.

Table 3 shows a comparison between the concentrations of non-methane hydrocarbons in the boxes.

**Table 3**

| Concentrations of non-methane hydrocarbons in the boxes | | | | | | |
|---|---|---|---|---|---|---|
| Comparative Examples | | Box shown in FIG. 1 | Box shown in FIG. 2 | | Box shown in FIG. 3 | |
| | | | Organic gas removal unit | | Organic gas removal unit | |
| Cleanroom | PC | | Yes | No | Yes | No |
| 0.8-1.1 | 1.1 | 1.1 | <0.1 | 1.1 | <0.1 | 1.1 |

As shown in Table 3, the concentration can be kept at a low level of 0.1 PPM in the boxes shown in FIGS. 2 and 3 each with the organic gas removal unit. In the absence of the organic gas removal unit, the concentration is of about 1.1 PPM as shown in Table 3. These data were obtained after 48 hours of storage of the semiconductor substrates.

The present invention has been described with respect to storage or delivery boxes for storing semiconductor substrates. However, the present invention is not limited to those boxes, but is also applicable to shelves for storing semiconductor substrates or cases for storing or delivering semiconductor substrates one by one. Silicon wafers have been described as an example of semiconductor substrates, the present invention is also applicable to various substrates on which natural oxide films can possibly be grown.

According to the present invention, as described above, the generation of a natural oxide film on the surface of a semiconductor substrate is suppressed by storing the semiconductor substrate in a box or a space whose outer wall is made of a light-shielding material. Since the generation of a natural oxide film within air can be suppressed, it is not necessary to use an N₂ gas atmosphere or a vacuum atmosphere, and a semiconductor substrate which is being processed can be stored or delivered simply and economically. Because the outer wall material is covered with a thin metal film as a light-shielding means, contaminant gases are prevented from being emitted from the outer wall material, making it more effective to suppress the generation of a natural oxide film.

The generation of a natural oxide film on the surface of a semiconductor substrate can be suppressed more effectively by providing a means for trapping and removing organic gases within the box or the space.

In each of the above embodiments, a means for simultaneously removing organic gases and fine particles may be incorporated to provide a general contamination removal system that can be used in many applications for controlling contamination in a wide range.

### Industrial Applicability

The present invention may preferably be applied to delivery boxes (carrier boxes), stockers, clean boxes, delivery spaces, interfaces (transfer devices), etc. for silicon semiconductor substrates, metal-covered substrates, etc. in high-technology industries such as semiconductor products fabrication industries.

## Claims

1. A method of preventing a surface of a substrate from being oxidized, **characterized by** storing the substrate in a light-shielded closed space to suppress a growth of a natural oxide film on the substrate.

2. A method according to claim 1, wherein said substrate is stored in said space while removing a gaseous contaminant or both a gaseous contaminant and a particulate substance.

3. A method according to claim 1 or 2, wherein light having a wavelength of 1500 nm or lower is reduced to an illuminance of 10 lux or lower to shield the space against light.

4. A method according to claim 2, wherein said gaseous contaminant contains an organic gas.

5. An apparatus for preventing a surface of a substrate from being oxidized, **characterized by** a closed space for storing the substrate and a light-shielded outer wall surrounding said space.

6. An apparatus according to claim 5, further comprising means for removing a gaseous contaminant or both a gaseous contaminant and a particulate substance in said space.

7. An apparatus according to claim 6, wherein said means for removing a gaseous contaminant or both a gaseous contaminant and a particulate substance in said space has means for circulating a gas in said space.

8. An apparatus according to claim 5, wherein said space comprises a space within a container or a storage device for delivering or storing a semiconductor substrate or a space within a delivery space.

9. An apparatus according to claim 8, wherein said light-shielded outer wall comprises an outer wall for reducing light having a wavelength of 1500 nm or lower to an illuminance of 10 lux or lower.

10. An apparatus according to claim 5, wherein said outer wall surrounding said space comprises a transparent material coated with a light-shielding material.

11. An apparatus according to claim 10, wherein said light-shielding material comprises a metal or an oxide thereof.

12. An apparatus according to claim 6, wherein said means for removing a gaseous contaminant or both a gaseous contaminant and a particulate substance comprises at least one of activated carbon, an ion exchange body, and a dehumidifier which is disposed within said closed space.

13. An apparatus according to claim 6, wherein said means for removing a gaseous contaminant or both a gaseous contaminant and a particulate substance comprises a photo-catalyst, a light source for applying light to said photo-catalyst, and a surrounding member for shielding the substrate to be stored against light from said light source, and wherein said photo-catalyst, said light source, and said surrounding member are disposed within said space.

14. An apparatus according to claim 6, wherein said means for removing a gaseous contaminant or both a gaseous contaminant and a particulate substance comprises one or more filters selected from a particle removal filter, a HEPA filter, an ULPA filter, ion exchange fiber, an activated carbon filter, a zeolite filter, and a dehumidifying filter.

15. An apparatus according to claim 13, wherein said photo-catalyst comprises TiO₂.

16. An apparatus according to claim 6, wherein said means for removing a gaseous contaminant and a particulate substance comprises a photo-electron emitter, a light source for enabling said photo-electron emitter to emit photo-electrons, an electrode for trapping charged particles of a particulate material to which emitted photo-electrons are applied, and a surrounding member for shielding the substrate to be stored against light from said light source, and wherein said photo-electron emitter, said light source, said electrode, and said surrounding member are disposed within said space.

17. An apparatus according to claim 16, wherein said photo-electron emitter comprises TiO₂.
